# EUROPÄISCHE PATENTSCHRIFT

(11) **EP 2 119 316 B1**
(45) Veröffentlichungstag und Bekanntmachung des Hinweises auf die Patenterteilung: **21.09.2011**
(21) Anmeldenummer: 07703933.7
(22) Anmeldetag: 17.01.2007
(51) Int. Cl.: H05B 33/08, G05D 23/20, G02B 26/08

(54) **LED-MODUL**
LED MODULE
MODULE DE DIODE ÉLECTROLUMINESCENTE

(43) Veröffentlichungstag der Anmeldung: 18.11.2009
(73) Patentinhaber: OSRAM Gesellschaft mit beschränkter Haftung, 81543 München (DE)
(72) Erfinder: HYING, Ralf, 81827 München (DE); NIEDERMEIER, Peter, 80995 München (DE); SCHALLMOSER, Oskar, 85521 Ottobrunn (DE)
(86) Internationale Anmeldenummer: PCT/EP2007/050433
(87) Internationale Veröffentlichungsnummer: WO 2008/086890

(56) Entgegenhaltungen:
- EP-A2- 0 618 653
- WO-A-2006/052682
- DE-A1- 3 422 297
- US-A1- 2002 179 816

## Beschreibung

### Technisches Gebiet

Die vorliegende Erfindung betrifft ein LED-Modul mit einer thermisch leitfähigen Platine, mindestens einem LED-Chip, der auf der thermisch leitfähigen Platine montiert ist, mindestens einem Temperatursensor, der auf der thermisch leitfähigen Platine montiert ist zur Bestimmung der Temperatur des mindestens einen LED-Chips, eine optische Anordnung, die über dem mindestens einen LED-Chip angeordnet ist und auf der thermisch leitfähigen Platine montiert ist, wobei die optische Anordnung mindestens einen lichtleitenden Abschnitt aufweist. Sie betrifft überdies eine Schaltungsanordnung mit mindestens einem derartigen LED-Modul.

### Stand der Technik

Die Problematik, mit der sich die vorliegende Erfindung beschäftigt, basiert darauf, dass sich die Effizienz von LED-Chips, wie sie beispielsweise für Front- und Rückprojektionsanwendungen eingesetzt werden, zum einen im Betrieb in Abhängigkeit der Temperatur und zum anderen über die Lebensdauer ändert. Werden LED-Chips unterschiedlicher Farbe eingesetzt, ändert sich dadurch der Farbort des durch Überlagerung des Lichts der einzelnen LED-Chips gebildeten Summenlichts.

Bei so genannten DMDs (Digital Mirror Device = Mikrospiegelvorrichtung) wird im Stand der Technik das von den LED-Chips abgegebene Licht im so genannten Sumpf gemessen, d. h. an dem Ort, an den das Licht durch die Spiegel abgelenkt wird, wenn es nicht durch die Optik nach außen geleitet werden soll. Dort im Sumpf ist dann ein Lichtsensor angebracht, der die Änderungen im Licht messen kann.

Die Schrift WO 2006/052682 (Oldham) beschreibt ein Analyse-System, bei dem eine Probe (z. B. eine Flüssigkeit, die DNA enthält) von LED Licht bestrahlt wird und die Reaktion der Probe von einem Detektor erfasst wird. Die Temperatur des LED Arrays wird dabei geregelt.

Die Schrift DE 3422297 A1 (Brodhag) beschreibt eine Bildbühne für ein fotographisches Vergrößerungsgerät. Eine Lichtmesseinrichtung mit Lichtsensoren und Lichtleitstäben tastet durch die Drehbewegung einer Spindel einen Film ab.

Die Schrift EP0681653 A2 (Shiozawa) betrifft die Frequenzstabilisierung eines Halbleiterlasers. In einem Ausführungsbeispiel werden zwei Kühlkörper mit jeweils einem Temperatursensor zur Temperatureinstellung verwendet. Auf einem Kühlkörper ist der Halbleiterlaser auf dem anderen Kühlkörper ist ein optischer Resonator und ein Photodetektor angebracht.

Die Schrift US 2002/0179816 A1 (Haines) beschreibt einen Beleuchtungskopf mit LEDs als Lichtquelle, bei dem der Ausfall einzelner LEDs und Temperaturabhängigkeiten ausgeregelt werden.

Nachteilig an diesem Stand der Technik ist, dass der Empfindlichkeitsbereich des im Sumpf angebrachten Lichtsensors auf das vom LED-Modul abgegebene Licht abgestimmt sein muss. Wenn nun ein nicht zum LED-Modul passender Lichtsensor eingesetzt wird, führt dies zu falschen Messergebnissen. Wenn dann ausgehend von dem vom Lichtsensor gelieferten Signal ein Regelkreis angesteuert werden soll, der zum Beispiel die Helligkeit und/oder den Farbort des von den LED-Chips abgegebenen Lichts konstant halten soll, so ist ein zuverlässiges Funktionieren eines derartigen Regelkreises nicht zu gewährleisten. Entsprechendes gilt wenn ein passender Lichtsensor falsch justiert im Sumpf eingebaut wird. Ein umständliches Nachjustieren oder ein aufwendiges Anpassen des zur Regelung verwendeten Regelkreises ist die Folge.

### Darstellung der Erfindung

Die Aufgabe der vorliegenden Erfindung besteht deshalb darin, ein gattungsgemäßes LED-Modul derart weiterzubilden, dass eine Regelung einer Eigenschaft des von den LED-Chips abgegebenen Lichts zuverlässiger ermöglicht wird.

Diese Aufgabe wird gelöst durch ein LED-Modul mit den Merkmalen von Patentanspruch 1.

Die vorliegende Erfindung basiert auf der Erkenntnis, dass eine zuverlässigere Regelung als bei der aus dem

Stand der Technik bekannten Vorgehensweise ermöglicht wird, wenn der Lichtsensor bereits Teil des LED-Moduls ist. Erfindungsgemäß weist demnach das LED-Modul einen auf der thermisch leitfähigen Platine angeordneten Lichtsensor auf, der so zu dem mindestens einen lichtleitenden Abschnitt angeordnet ist, dass er im lichtleitenden Abschnitt geführtes Licht sensieren kann.

Damit ist herstellerseitig sichergestellt, dass immer ein zu den jeweiligen LED-Chips passender Lichtsensor für die Regelung mindestens einer Eigenschaft des von den LED-Chips abgegebenen Lichts bereitgestellt wird. Dieser ist überdies bereits herstellerseitig richtig justiert, Falschmessungen sind daher ausgeschlossen. Ein nachträgliches Anpassen des Regelkreises oder ein aufwendiges Nachjustieren kann entfallen. Da der Lichtsensor überdies auf der thermisch leitfähigen Platine montiert wird, wo schon der Temperatursensor sowie die LED-Chips montiert sind, kann dies quasi in einem Arbeitsvorgang erledigt werden. Ein aufwändiges Einsetzen des Lichtsensors im Sumpf, wie dies beim Stand der Technik nötig war, d. h. eines einzigen elektronischen Bauelements innerhalb einer bestimmten Umgebung, sowie die dafür benötigte Verkabelung können damit entfallen.

Bevorzugt weist die thermisch leitfähige Platine einen schichtartigen Aufbau vor, wobei eine Schicht, insbesondere der Kern, aus einem Metall, bevorzugt aus Aluminium oder Kupfer, besteht. Dadurch kann eine derart gute thermische Leitfähigkeit erzielt werden, dass ein einziger Temperatursensor ausreicht, der eine Bestimmung der Temperatur des mindestens einen LED-Chips und des Lichtsensors ermöglicht. Damit lässt sich ein vollständig geeichtes System aufbauen, das bereits in der Fertigung vermessen, gegebenenfalls kalibriert und hinsichtlich seiner Fehlerfreiheit beurteilt werden kann. Die mit dem LED-Modul aus dem Stand der Technik einhergehenden Unwägbarkeiten durch Verwendung eines fehlerhaften oder ungeeigneten oder falsch justierten Lichtsensors können damit bereits herstellerseitig ausgeschlossen werden.

Bevorzugt ist der mindestens eine lichtleitende Abschnitt der optischen Anordnung, insbesondere die gesamte optische Anordnung, aus lichtleitendem Material gebildet. Darunter fallen bevorzugt Materialien wie Glas, Plexiglas sowie weitere lichtleitende Kunststoffe. Diese optische Anordnung dient bei dem bereits erwähnten bevorzugten Anwendungsgebiet von DMDs dazu, das Licht des mindestens einen LED-Chips auf das Mikrodisplay zu lenken.

Der Lichtsensor ist bevorzugt zwischen dem lichtleitenden Abschnitt und der thermisch leitfähigen Platine angeordnet. Dies eröffnet die Möglichkeit, den Lichtsensor in einem Arbeitsgang zusammen mit den anderen Bauelementen auf der Platine zu montieren, wobei die optische Anordnung in einem weiteren Arbeitsgang auf der Platine angeordnet wird. Im Bereich des Lichtsensors weist daher die optische Anordnung einen Ausschnitt auf, der der Höhle des Lichtsensors - und je nach Breite des Lichtsensors auch dessen Breite - Rechnung trägt.

Besonders bevorzugt ist dabei, wenn die optische Anordnung mindestens eine Kante und mindestens eine Linse aufweist, wobei der lichtleitende Abschnitt von der Kante gebildet wird, wobei die Kante derart zur Linse angeordnet ist, dass in der Kante Licht geführt wird, das mit dem durch die Linse fallenden Licht korreliert ist. Da das Verhältnis aus Streulicht, das letztendlich auf den Lichtsensor fällt, zu emittiertem Licht, das ist das Licht, das durch die Linse geht, im Wesentlichen konstant ist, ist daher eine Eichung möglich. Das auf dem Lichtsensor eintreffende Licht kann daher zuverlässig zur Beurteilung der Eigenschaften des Lichts, das durch die Linse fällt, verwendet werden.

Das LED-Modul umfasst bevorzugt mehrere LED-Chips, wobei die LED-Chips ausgelegt sind, Licht unterschiedlicher Farbe oder gleicher Farbe abzugeben. Besonders bevorzugt bei Projektionsanwendungen ist, wenn LED-Chips vorgesehen sind für die Farben Rot, Grün und Blau.

Wie bereits erwähnt, kann bei einer bevorzugten Ausführungsform der Temperatursensor so angeordnet sein, dass er zur Bestimmung auch der Temperatur des Lichtsensors geeignet ist. Es kann jedoch auch vorgesehen werden, dass ein weiterer Temperatursensor zur Bestimmung der Temperatur des Lichtsensors vorgesehen ist. Damit lassen sich dann noch genauere Messungen und damit Eichungen des Systems vornehmen, insbesondere die Phase kurz nach Einschalten eines erfindungsgemäßen LED-Moduls betreffend, während der der Lichtsensor und das LED-Modul infolge der Trägheit der thermischen Konvektion noch nicht auf derselben Temperatur sind.

Gemäß einem zweiten Aspekt betrifft die vorliegende Erfindung auch eine Schaltungsanordnung mit mindestens einem erfindungsgemäßen LED-Modul.

Besonders bevorzugt weist eine derartige Schaltungsanordnung weiterhin eine Regelvorrichtung auf, die ausgelegt ist, aus dem vom Lichtsensor bereitgestellten Signal den Ist-Wert mindestens einer Eigenschaft des von dem mindestens einen LED-Chip abgegebenen Lichts zu ermitteln und diesen auf den von einer Sollwertvorgabevorrichtung bereitgestellten Sollwert der mindestens einen Eigenschaft zu regeln. Dem Fachmann sind einschlägige, dafür geeignete Regelalgorithmen bekannt. Beispielhaft sei verwiesen auf den in der Schrift DE102005049579 vorgestellten Regelalgorithmus.

Die mindestens eine Eigenschaft, auf die geregelt wird, ist bevorzugt die Helligkeit oder der Farbort des von dem mindestens einen LED-Chip abgegebenen Lichts. Damit lässt sich dann diese Eigenschaft über die Temperatur und die Lebensdauer des mindestens einen LED-Chips unter Berücksichtigung gewisser Grenzen einhalten.

Besonders bevorzugt erfolgt die Regelung unter Berücksichtigung der Temperatur des Lichtsensors. Damit können bei der Regelung auch die Temperaturabhängigkeiten des Lichtsensors, der üblicherweise auch als Halbleiterbauelement realisiert ist, ausgeregelt werden, wodurch sich eine noch genauere Konstanthaltung der mindestens einen Eigenschaft des Lichts des mindestens einen LED-Chips erreichen lässt.

Ein erfindungsgemäßes LED-Modul bzw. eine erfindungsgemäße Schaltungsanordnung kann grundsätzlich in allen Projektionsanwendungen, unabhängig vom Bildmodulator (DMD, LCD = Liquid Crystal Device, LCOS = Liquid Crystal on Silicon) eingesetzt werden. Des Weiteren eignet es sich auch für andere Anwendungsgebiete, in denen LED-Module eingesetzt werden, beispielsweise in der Allgemeinbeleuchtung (General Lighting).

Weitere vorteilhafte Ausführungsformen ergeben sich aus den Unteransprüchen.

### Kurze Beschreibung der Zeichnung(en)

Im Nachfolgenden wird nunmehr ein Ausführungsbeispiel eines erfindungsgemäßen LED-Moduls unter Bezugnahme auf die beigefügten Zeichnungen näher beschrieben. Es zeigen:
Fig. 1 in schematischer Darstellung den Aufbau eines erfindungsgemäßen LED-Moduls; und
Fig. 2 in schematischer Darstellung den Aufbau einer erfindungsgemäßen Schaltungsanordnung.

### Bevorzugte Ausführung der Erfindung

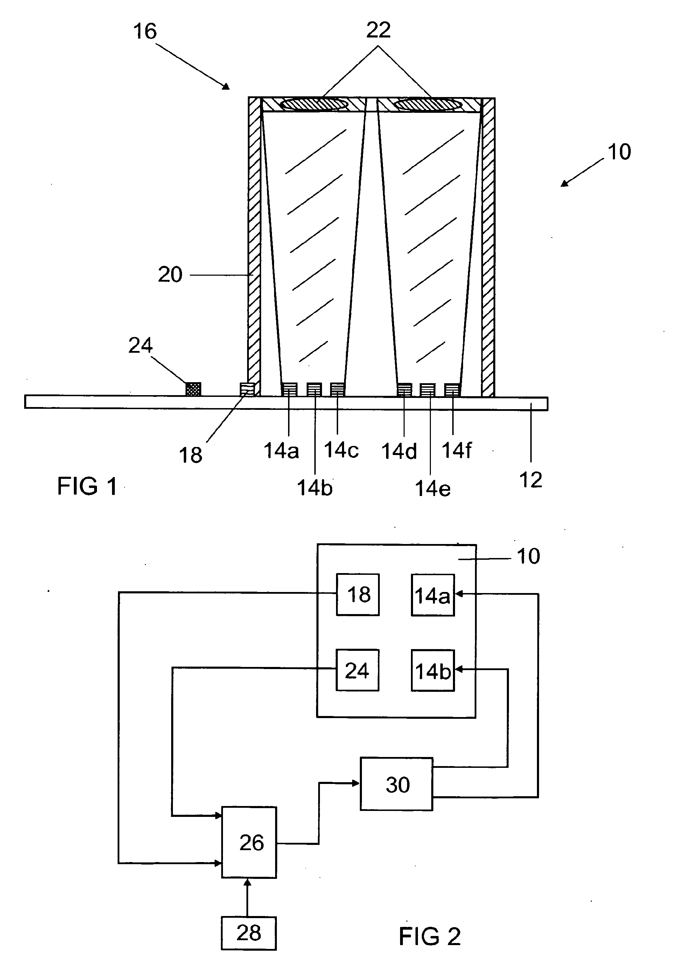

Fig. 1 zeigt in schematischer Darstellung den Aufbau eines erfindungsgemäßen LED-Moduls 10. Dabei sind auf einer thermisch leitfähigen Platine 12, die bevorzugt einen schichtartigen Aufbau aufweist, wobei die eine Schicht, insbesondere der Kern, aus einem Metall, bevorzugt Aluminium oder Kupfer, besteht, mehrere LED-Chips 14a bis 14f angeordnet. Diese LED-Chips 14a bis 14f können Licht unterschiedlicher Farbe oder auch Licht gleicher Farbe abgeben. Über diesen ist als optische Anordnung eine Primäroptik 16 vorgesehen, wobei vorliegend die Bereiche, die aus optisch lichtleitendem Material bestehen, schraffiert dargestellt sind. Ein erfindungsgemäßes LED-Modul 10 weist weiterhin einen Lichtsensor 18 auf, der so in einer Kante 20 der optischen Anordnung 16 angeordnet ist, dass Streulicht des durch Linsen 22 der optischen Anordnung 16 hindurchgehenden Lichts auf den Lichtsensor 18 fällt. Das vom Lichtsensor 18 sensierte Licht ist damit hinsichtlich mindestens einer Eigenschaft mit dem durch die Linsen 22 der optischen Anordnung hindurchgehenden Licht korreliert, beispielsweise im Hinblick auf die Helligkeit oder den Farbort. Das erfindungsgemäße LED-Modul 10 weist überdies einen Temperatursensor 24 auf, der so zu den LED-Chips 14a bis 14f und dem Lichtsensor 18 angeordnet ist, dass er zur Bestimmung derer Temperatur geeignet ist. Anstelle des gemäß der Ausführungsform von Fig. 1 vorgesehenen einen Temperatursensors können auch mindestens zwei Temperatursensoren vorgesehen sein, um ein noch präziseres Bestimmen der Temperatur des mindestens einen LED-Chips 14a bis 14f und des Lichtsensors 18 zu ermöglichen.

Fig. 2 zeigt in schematischer Darstellung den Aufbau einer erfindungsgemäßen Schaltungsanordnung. Sie umfasst mindestens ein erfindungsgemäßes LED-Modul 10, das seinerseits einen Lichtsensor 18 sowie einen Temperatursensor 24 umfasst und vorliegend zwei LED-Chips 14a und 14b. Die Messwerte des Lichtsensors 24 und des Temperatursensors 18 werden einer Regelvorrichtung 26 zugeführt, die mindestens einen Sollwert mindestens einer Eigenschaft des von den LED-Chips 14a, 14b abgegebenen Lichts von der Sollwertvorgabevorrichtung 28 bereitgestellt erhält. Die Regelvorrichtung 26, in der ein entsprechender Regelalgorithmus abgelegt ist, liefert daraufhin ein entsprechendes Signal an eine Ansteuervorrichtung 30, die ihrerseits nunmehr die LED-Chips 14a, 14b zur Einstellung des von der Sollwertvorgabevorrichtung 28 vorgegebenen mindestens einen Sollwerts ansteuert.

## Patentansprüche

1. LED-Modul (10) mit
- einer thermisch leitfähigen Platine (12),
- mindestens einem LED-Chip (14a bis 14f), der auf der thermisch leitfähigen Platine (12) montiert ist;
- mindestens einem Temperatursensor (24), der auf der thermisch leitfähigen Platine (12) montiert ist zur Bestimmung der Temperatur des mindestens einen LED-Chips (14a bis 14f);
- eine optische Anordnung (16), die über dem mindestens einen LED-Chip (14a bis 14f) angeordnet und auf der thermisch leitfähigen Platine (12) montiert ist, wobei die optische Anordnung (16) mindestens einen lichtleitenden Abschnitt (20) aufweist;
- einen auf der thermisch leitfähigen Platine (12) angeordneten Lichtsensor (18), der so zwishen dem lichtleitenden Abschnitt (20) und der thermish leitfähigen Platine (12) angeordnet ist, , dass er im lichtleitenden Abschnitt (20) geführtes Licht sensieren kann, **dadurch gekennzeichnet, dass** der mindestens eine lichtleitende Abschnitt (20) der optischen Anordnung (16), insbesondere die gesamte optische Anordnung (16), aus lichtleitendem Material gebildet ist, wobei die optische Anordnung (16) mindestens eine Kante (20) und mindestens eine Linse (22) aufweist, und der lichtleitende Abschnitt von der Kante (20) gebildet wird, wobei die Kante (20) derart zur Linse (22) angeordnet ist, dass in der Kante (20) Licht geführt wird, das mit dem durch die Linse (22) fallenden Licht korreliert ist.

2. LED-Modul (10) nach Anspruch 1,
**dadurch gekennzeichnet,**
**dass** die thermisch leitfähige Platine (12) einen schichtartigen Aufbau aufweist, wobei eine Schicht, insbesondere der Kern, aus einem Metall, bevorzugt Aluminium oder Kupfer, besteht.

3. LED-Modul (10) nach einem der vorhergehenden Ansprüche,
**dadurch gekennzeichnet,**
**dass** das LED-Modul (10) mehrere LED-Chips (14a bis 14f) umfasst, wobei die LED-Chips (14a bis 14f) ausgelegt sind, Licht unterschiedlicher Farbe oder gleicher Farbe abzugeben.

4. LED-Modul (10) nach einem der vorhergehenden Ansprüche,
**dadurch gekennzeichnet,**
**dass** der Temperatursensor (24) so angeordnet ist, dass er zur Bestimmung der Temperatur des Lichtsensors (18) geeignet ist.

5. LED-Modul (10) nach einem der Ansprüche 1 bis 4,
**dadurch gekennzeichnet,**
**dass** ein weiterer Temperatursensor zur Bestimmung der Temperatur des Lichtsensors (18) vorgesehen ist.

6. Schaltungsanordnung mit mindestens einem LED-Modul (10) nach einem der vorhergehenden Ansprüche.

7. Schaltungsanordnung nach Anspruch 6,
**dadurch gekennzeichnet,**
**dass** sie weiterhin eine Regelvorrichtung (26) umfasst, die ausgelegt ist, aus dem vom Lichtsensor (18) bereitgestellten Signal den Ist-Wert mindestens einer Eigenschaft des von dem mindestens einen LED-Chip (14a bis 14f) abgegebenen Lichts zu ermitteln und diesen auf den von einer Sollwertvorgabevorrichtung (28) bereitgestellten Sollwert der mindestens einen Eigenschaft zu regeln.

8. Schaltungsanordnung nach einem der Ansprüche 6 oder 7,
**dadurch gekennzeichnet,**
**dass** die mindestens eine Eigenschaft die Helligkeit oder der Farbort des von dem mindestens einen LED-Chip (14a bis 14f) abgegebenen Lichts ist.

9. Schaltungsanordnung nach einem der Ansprüche 7 oder 8,
**dadurch gekennzeichnet,**
**dass** die Regelung unter Berücksichtigung der Temperatur des Lichtsensors (18) erfolgt.

## Claims

1. LED module (10) comprising
- a thermally conductive circuit board (12),
- at least one LED chip (14a to 14f) mounted on the thermally conductive circuit board (12);
- at least one temperature sensor (24) mounted on the thermally conductive circuit board (12), for determining the temperature of the at least one LED chip (14a to 14f);
- an optical arrangement (16), which is arranged above the at least one LED chip (14a to 14f) and is mounted on the thermally conductive circuit board (12), wherein the optical arrangement (16) has at least one light-guiding section (20);
- a light sensor (18) arranged on the thermally conductive circuit board (12), said light sensor being arranged between the light-guiding section (20) and the thermally conductive circuit board (12) in such a way that it can sense light guided in the light-guiding section (20), **characterized in that** the at least one light-guiding section (20) of the optical arrangement (16), in particular the entire optical arrangement (16), is formed from light-guiding material, wherein the optical arrangement (16) has at least one edge (20) and at least one lens (22), and the light-guiding section is formed by the edge (20), wherein the edge (20) is arranged with respect to the lens (22) in such a way that light which is correlated with the light passing through the lens (22) is guided in the edge (20).

2. LED module (10) according to Claim 1,
**characterized**
**in that** the thermally conductive circuit board (12) has a layered construction, wherein one layer, in particular the core, is composed of a metal, preferably aluminum or copper.

3. LED module (10) according to any of the preceding claims,
**characterized**
**in that** the LED module (10) comprises a plurality of LED chips (14a to 14f), wherein the LED chips (14a to 14f) are designed to emit light of different colors or the same color.

4. LED module (10) according to any of the preceding claims,
**characterized**
**in that** the temperature sensor (24) is arranged in such a way that it is suitable for determining the temperature of the light sensor (18).

5. LED module (10) according to any of Claims 1 to 4,
**characterized**
**in that** provision is made of a further temperature sensor for determining the temperature of the light sensor (18).

6. Circuit arrangement comprising at least one LED module (10) according to any of the preceding claims.

7. Circuit arrangement according to Claim 6,
**characterized**
**in that** it furthermore comprises a control device (26), which is designed to determine, from the signal provided by the light sensor (18), the actual value of at least one property of the light emitted by the at least one LED chip (14a to 14f) and to control said value to the desired value of the at least one property, said desired value being provided by a desired value predefining device (28).

8. Circuit arrangement according to either of Claims 6 and 7,
**characterized**
**in that** the at least one property is the brightness or the color locus of the light emitted by the at least one LED chip (14a to 14f).

9. Circuit arrangement according to either of Claims 7 and 8,
**characterized**
**in that** the control is effected taking account of the temperature of the light sensor (18).

## Revendications

1. Module DEL (10) comprenant
- une platine thermoconductrice (12),
- au moins une puce DEL (14a à 14f) montée sur la platine thermoconductrice (12) ;
- au moins un capteur de température (24) monté sur la platine thermoconductrice (12), destiné à déterminer la température de ladite au moins une puce DEL (14a à 14f) ;
- un dispositif optique (16) disposé au-dessus de ladite au moins une puce (14a à 14f) et monté sur la platine thermoconductrice (12), ledit dispositif optique (16) présentant au moins une partie conductrice de lumière (20) ;
- un capteur de lumière (18) monté sur la platine thermoconductrice (12), disposé entre la partie conductrice de lumière (20) et la platine thermoconductrice (12) de façon à pouvoir capter de la lumière guidée dans la partie conductrice de lumière (20), **caractérisé en ce que** ladite au moins une partie conductrice de lumière (20) du dispositif optique (16), en particulier l'ensemble du dispositif optique (16), est formé(e) par un matériau conducteur de lumière, le dispositif optique (16) présentant au moins une arête (20) et au moins une lentille (22), et **en ce que** ladite partie conductrice de lumière (20) est formée par l'arête (20), l'arête (20) étant disposée de telle façon par rapport à la lentille (22) que de la lumière est guidée dans l'arête (20), lumière qui est en corrélation avec la lumière traversant la lentille (22).

2. Module DEL (10) selon la revendication 1,
**caractérisé en ce que** la platine thermoconductrice (12) présente une structure de type sandwich, dont une couche, en particulier le cour, est constitué(e) d'un métal, de préférence d'aluminium ou de cuivre.

3. Module DEL (10) selon l'une des revendications précédentes,
**caractérisé en ce que** le module DEL (10) comprend plusieurs puces DEL (14a à 14f), lesdites puces DEL (14a à 14f) étant conçues pour émettre de la lumière de couleurs différentes ou de même couleur.

4. Module DEL (10) selon l'une des revendications précédentes,
**caractérisé en ce que** le capteur de température (24) est disposé de façon à être apte à déterminer la température du capteur de lumière (18).

5. Module DEL (10) selon l'une des revendications 1 à 4, **caractérisé en ce qu'**il est prévu un autre capteur de température pour déterminer la température du capteur de lumière (18).

6. Circuit comprenant au moins un module DEL (10) selon l'une des revendications précédentes.

7. Circuit selon la revendication 6,
**caractérisé en ce qu'**il comprend en outre un dispositif de réglage (26), conçu pour déterminer à partir du signal fourni par le capteur de lumière (18) la valeur réelle d'au moins une propriété de la lumière émise par ladite au moins une puce DEL (14a à 14f) et pour régler celle-ci sur la valeur de consigne de ladite au moins une propriété, fournie par un dispositif d'allocation de valeur de consigne (28).

8. Circuit selon l'une des revendications 6 ou 7, **caractérisé en ce que** ladite au moins une propriété est la luminosité ou la localisation chromatique de la lumière émise par ladite au moins une puce DEL (14a à 14f).

9. Circuit selon l'une des revendications 7 ou 8, **caractérisé en ce que** le réglage s'effectue en tenant compte de la température du capteur de lumière (18).
